# DEMANDE DE BREVET EUROPEEN

(11) **EP 3 812 108 A1**
(43) Date de publication de la demande: **28.04.2021**
(21) Numéro de dépôt: 20202885.8
(22) Date de dépôt: 20.10.2020
(51) Int. Cl.: B25J 9/16, B25J 15/06, H01L 21/683, H01L 31/18, B25J 11/00, B25J 15/00

(54) **PROCÉDÉ DE RÉGLAGE D'UN SYSTÈME DE PRÉHENSION DESTINÉ À SAISIR AU MOINS UNE PLAQUE**

(30) Priorité: 25.10.2019 FR 1912003
(71) Demandeur: COMMISSARIAT À L'ÉNERGIE ATOMIQUE ET AUX ÉNERGIES ALTERNATIVES, 75015 Paris (FR)
(72) Inventeur: JERONIMO, Pedro, 38054 GRENOBLE cedex 09 (FR)
(74) Mandataire: INNOV-GROUP

(57) **Abrégé**

Le procédé de réglage permet de régler un système (101) de préhension. Le système (101) de préhension est destiné à saisir au moins une plaque, la plaque étant destinée à la formation d'une cellule photovoltaïque. Le procédé de réglage comporte : une étape de sollicitation du système (101) de préhension contre un dispositif (102) de détection configuré pour détecter des contraintes ; une étape de détection de contraintes exercées par le système (101) de préhension sur le dispositif (102) de détection au cours de l'étape de sollicitation ; une étape d'analyse des contraintes détectées ; une étape de réglage du système (101) de préhension en prenant en compte l'analyse des contraintes détectées.

## Description

### Domaine technique de l'invention

Le domaine technique de l'invention concerne la préhension d'une ou de plusieurs plaques en vue de les déplacer, par exemple, selon une direction orthogonale au plan de la ou des plaques. Plus particulièrement, l'invention est relative à un procédé de réglage d'un système de préhension, le système de préhension étant destiné à saisir au moins une plaque, cette plaque étant destinée à la formation d'une cellule photovoltaïque.

### État de la technique

Dans le domaine de la fabrication de cellules photovoltaïques, il est connu de saisir des plaques, destinées à la formation de ces cellules photovoltaïques, placées sur un support afin de les positionner sur un plateau de transport en vue de les traiter dans un dispositif de traitement au sein duquel lequel ce plateau de transport peut se déplacer. Le support peut être un convoyeur à bande. Un tel dispositif de traitement peut être du type permettant un dépôt PECVD (abréviation de « Plasma-Enhanced Chemical Vapor Déposition » en anglais correspondant en français à dépôt chimique en phase vapeur assisté par plasma) sur ces plaques. Pour saisir les plaques placées sur le support, il peut être utilisé un système de préhension comportant des dispositifs de préhension. Chaque dispositif de préhension comporte plusieurs ventouses, par exemple au nombre de quatre, pour saisir une plaque correspondante grâce à l'adhésion de chacune des ventouses à la plaque par vide partiel. Le vide partiel peut être réalisé par aspiration. Les dispositifs de préhension peuvent être agencés en ligne pour saisir simultanément une ligne de plaques.

Les dispositifs de préhension sont notamment agencés pour être déplacés simultanément, lors de la préhension des plaques, selon un axe Z et préférentiellement uniquement selon cet axe. L'axe Z peut être un axe vertical. On parle aussi dans le domaine d'axe numérique en Z. Autrement dit, lorsque les plaques doivent être saisies par les dispositifs de préhension, les plaques portées par le support sont, par exemple, placées chacune sous un dispositif de préhension correspondant et le déplacement des dispositifs de préhension est alors réalisé en faisant varier la hauteur des dispositifs de préhension par rapport aux plaques pour saisir les plaques toutes en même temps puis pour écarter les plaques par rapport au support. Après avoir saisi les plaques, le système de préhension peut être déplacé pour positionner les plaques au-dessus du plateau de transport sur lequel les plaques doivent être déposées. Ensuite, le système de préhension est abaissé pour positionner les plaques sur le plateau de transport, et les ventouses passent dans un état de relâchement où elles n'adhèrent plus aux plaques d'où il résulte que les plaques reposent sur le plateau de transport.

Il est difficile de savoir si les ventouses sont correctement réglées en hauteur selon l'axe Z les unes par rapport aux autres, c'est-à-dire qu'elles sont au même niveau par rapport à un plan horizontal.

Si pour un même dispositif de préhension devant saisir une plaque, la hauteur d'une première ventouse de ce dispositif de préhension par rapport à la plaque est plus basse que la hauteur d'une deuxième ventouse de ce dispositif de préhension par rapport à la plaque, il en résulte que, lors de la préhension de la plaque, la première ventouse va toucher la plaque en premier. Ensuite, la mise en contact de la deuxième ventouse avec la plaque est liée à l'application d'une pression sur la plaque, par la première ventouse, plus importante que la pression de la deuxième ventouse appliquée sur cette plaque. Cette différence de pression, nécessaire pour assurer que les première et deuxième ventouses présentant des hauteurs différentes adhèrent correctement à la plaque, peut être telle que la première ventouse génère une trace plus ou moins accentué, en fonction de la pression exercée par la ventouse, à la surface de la plaque. Cette trace n'est pas visible à l'œil nu, mais peut être détectée à l'aide d'un système de mesure par électroluminescence ou par photoluminescence. Lorsque la plaque sur laquelle la trace a été formée a subi tous les traitements pour devenir une cellule photovoltaïque, il résulte de la présence de cette trace une chute du rendement électrique de la cellule photovoltaïque par rapport au rendement qu'il aurait été possible d'obtenir sans cette trace. Par ailleurs, plus la trace est accentuée, plus le rendement de la cellule photovoltaïque est diminué. Dès lors, il existe un besoin de trouver une solution pour limiter l'accentuation de cette trace. Lorsque les dispositifs de préhension se déplacent tous en même temps, le même problème peut apparaître si les première et deuxième ventouses appartiennent chacune à des dispositifs de préhension distincts.

Il existe donc un besoin de trouver une solution pour limiter la différence de pression entre des pressions appliquées par exemple respectivement par deux ventouses lors de la préhension d'une plaque, ou de plusieurs plaques en simultané.

### Objet de l'invention

L'invention a pour but un procédé de réglage d'un système de préhension en vue d'améliorer la préhension d'au moins une plaque de préférence en cherchant à uniformiser des contraintes appliqués par le système de préhension saisissant la plaque ou plusieurs plaques.

A cet effet, l'invention est relative à un procédé de réglage d'un système de préhension, le système de préhension étant destiné à saisir au moins une plaque, la plaque étant destinée à la formation d'une cellule photovoltaïque. Le procédé de réglage est caractérisé en ce qu'il comporte : une étape de sollicitation du système de préhension contre un dispositif de détection configuré pour détecter des contraintes ; une étape de détection de contraintes exercées par le système de préhension sur le dispositif de détection au cours de l'étape de sollicitation ; une étape d'analyse des contraintes détectées ; une étape de réglage du système de préhension en prenant en compte l'analyse des contraintes détectées.

Ainsi, l'analyse des contraintes détectées lors de l'étape de sollicitation qui simule sur le dispositif de détection une préhension d'une ou de plusieurs plaques permet d'obtenir des données pertinentes pour régler le système de préhension de manière adaptée.

Le procédé de réglage peut en outre comporter une ou plusieurs des caractéristiques suivantes :
- l'étape d'analyse des contraintes détectées comporte : une étape de détection de différentes zones de contact entre le dispositif de détection et le système de préhension ; une étape de vérification d'une présence d'un décalage entre des moments de détection de deux zones de contact, ledit décalage étant représentatif d'une différence de niveau entre deux parties du système de préhension ;
   et, l'étape de vérification ayant conduit à la détection de la présence du décalage, l'étape de réglage du système de préhension prend en compte le décalage en vue de corriger la différence de niveau ;
- le système de préhension comporte des ventouses, les deux parties du système de préhension étant formées chacune par une des ventouses ;
- le système de préhension est configuré pour saisir plusieurs plaques, le système de préhension comportant une pluralité de dispositifs de préhension, chaque dispositif de préhension étant destiné à saisir une des plaques, et chaque contrainte détectée au cours de l'étape de détection de contraintes est une contrainte exercée par l'un des dispositifs de préhension ;
- le procédé de réglage est tel que les ventouses sont agencées de sorte que chaque dispositif de préhension comporte plusieurs ventouses, et l'étape de réglage du système de préhension ajuste le positionnement d'une ou de plusieurs des ventouses ;
- le procédé de réglage est tel que : le système de préhension appartient à un dispositif de chargement des plaques dans un dispositif de traitement des plaques, ledit dispositif de chargement étant configuré pour saisir, en utilisant le système de préhension, les plaques placées sur un support et pour les transférer sur un plateau de transport des plaques destiné à être inséré dans le dispositif de traitement des plaques ; le dispositif de détection est sur le support au cours de l'étape de sollicitation ;
- le dispositif de traitement est configuré pour réaliser un dépôt chimique en phase vapeur assisté par plasma sur les plaques ;
- l'étape d'analyse comporte une étape d'interprétation des contraintes détectées et une étape d'élaboration d'un indicateur pour restituer l'interprétation des contraintes détectées ;
- l'indicateur est une cartographie des contraintes exercées par le système de préhension sur le dispositif de détection au cours de l'étape de sollicitation.

Le procédé de réglage peut être tel que le réglage du système de préhension est réalisé, en vue de rendre plus uniforme les contraintes exercées par le système de préhension lors d'une préhension de la plaque, par correction d'un dérèglement correspondant à la présence d'au moins deux parties du système de préhension agencées à des niveaux différents par rapport à un plan de référence.

Le procédé de réglage peut être tel que le système de préhension permet de, c'est-à-dire est configuré pour, saisir la plaque par l'une de ses faces.

L'invention est aussi relative à une installation comportant un système de préhension pour au moins une plaque, la plaque étant destinée à la formation d'une cellule photovoltaïque, cette installation est caractérisée en ce qu'elle comporte : un dispositif de détection pour détecter des contraintes ; une configuration de réglage du système de préhension, ledit système de préhension étant configuré pour présenter, dans la configuration de réglage, une première configuration et une deuxième configuration, dans la première configuration le système de préhension étant à distance du dispositif de détection, dans la deuxième configuration le système de préhension étant sollicité contre le dispositif de détection ; une unité de calcul reliée au dispositif de détection pour analyser des contraintes détectées, dans la deuxième configuration, par le dispositif de détection en vue de réaliser un réglage du système de préhension.

Dans le cadre de l'installation, le dispositif de détection peut comporter une matrice de capteurs de pression.

Dans le cadre de l'installation, le dispositif de détection peut être un capteur de pression multipoint.

Dans le cadre de l'installation, le système de préhension étant configuré pour saisir une pluralité de plaques, l'installation comporte un dispositif de chargement des plaques dans un dispositif de traitement des plaques, ledit dispositif de chargement étant configuré pour saisir, en utilisant le système de préhension, les plaques placées sur un support et pour les transférer sur un plateau de transport des plaques destiné à être inséré dans le dispositif de traitement des plaques, et, dans la première configuration et dans la deuxième configuration, le dispositif de détection est sur le support.

D'autres caractéristiques et avantages pourront ressortir clairement de la description détaillée qui va suivre.

### Description sommaire des dessins

L'invention sera mieux comprise à la lecture de la description détaillée qui va suivre, donnée uniquement à titre d'exemple non limitatif et faite en se référant aux dessins annexés et listés ci-dessous.
La figure 1 illustre, selon une vue en perspective, un exemple de réalisation d'un système de préhension destiné à être réglé au cours d'un procédé de réglage selon un mode de réalisation de l'invention.
La figure 2 illustre, selon une vue en perspective, un exemple de dispositif de détection pour détecter des contraintes et utilisé au cours du procédé de réglage.
La figure 3 illustre, selon une vue en perspective, la préhension d'une plaque par le dispositif de préhension de la figure 1.
La figure 4 illustre schématique des étapes du procédé de réglage selon un mode de réalisation particulier de ce procédé de réglage.
La figure 5 illustre, selon une vue en perspective, la sollicitation du système de préhension de la figure 1 contre le dispositif de détection de la figure 2.
La figure 6 illustre une vue latérale de la figure 5 avant que toutes les ventouses d'un ensemble de ventouses ne soient mises en contact avec le dispositif de détection.
La figure 7 illustre, selon une vue en perspective, un système de préhension à trois dispositifs de préhension sollicités contre un dispositif de détection adapté.
La figure 8 illustre, selon une vue en perspective, un exemple de préhension de trois plaques positionnées sur un support, la préhension étant réalisée par trois dispositifs de préhension.
La figure 9 illustre schématique une unité de calcul reliée, d'une part, au dispositif de détection et, d'autre part, à un écran.
La figure 10 illustre schématiquement une installation pour le traitement d'une ou de plusieurs plaques au sein de laquelle le système de préhension est sollicité contre le dispositif de détection.
La figure 11 illustre schématiquement l'installation de la figure 10 pour laquelle le système de préhension est à distance du dispositif de détection.
La figure 12 illustre schématiquement une étape de saisie de plaques positionnées sur un support par le système de préhension au sein de l'installation pour le traitement de plaques.
La figure 13 représente schématiquement le positionnement des plaques sur un plateau de transport au sein de l'installation pour le traitement de plaques.

Sur ces figures, les mêmes références sont utilisées pour désigner les mêmes éléments.

### Description détaillée

Dans la présente description, par « compris entre deux valeurs », il est entendu que les bornes définies par ces deux valeurs sont incluses dans la plage de valeurs considérée.

Dans la présente description, par « accentué ou accentuation » en parlant d'une trace, il est entendu la manière dont cette trace est visible, par exemple en utilisant le système de mesure par électroluminescence ou par photoluminescence évoqué dans la partie état de la technique. Plus une trace est accentuée, plus elle est nette et donc visible.

Un déplacement, par exemple un rapprochement, selon un axe est entendu comme un déplacement dans une direction parallèle à cet axe.

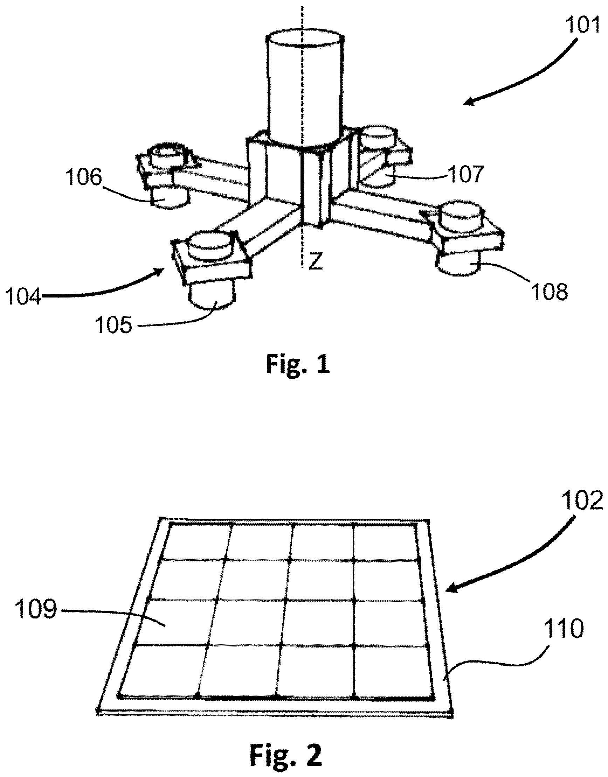

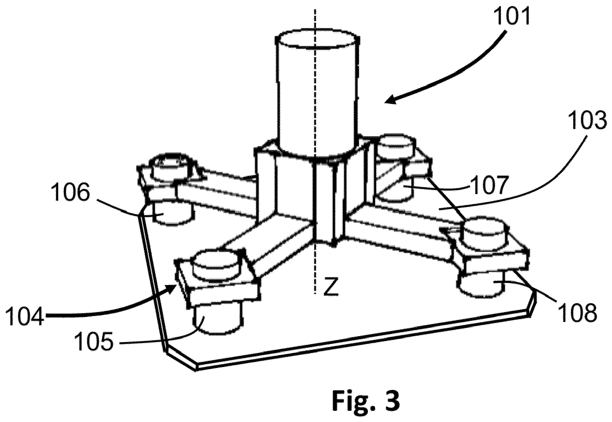

La présente invention peut permettre de vérifier si un système 101 de préhension, par exemple tel qu'illustré en figure 1, doit être réglé. Cette vérification étant notamment réalisée en utilisant un dispositif 102 de détection, par exemple tel qu'illustré en figure 2, configuré pour détecter des contraintes. Le réglage du système 101 de préhension en utilisant des données issues du dispositif 102 de détection permet préférentiellement d'homogénéiser, c'est-à-dire de rendre plus uniforme, des contraintes, c'est-à-dire les efforts, exercés par le système 101 de préhension sur au moins une plaque 103 qu'il est destiné à saisir comme le montre à titre l'exemple la figure 3.

Le système 101 de préhension pour ladite au moins une plaque 103 au sens de la présente description permet la préhension, c'est-à-dire de saisir, la plaque 103 ou plusieurs plaques 103. Bien entendu, le système 101 de préhension peut relâcher la ou les plaques 103 saisies, c'est-à-dire cesser l'action de maintien de la ou des plaques, par exemple au terme d'un transfert de la ou des plaques 103 sur un plateau 116 de transport comme cela sera vu par la suite.

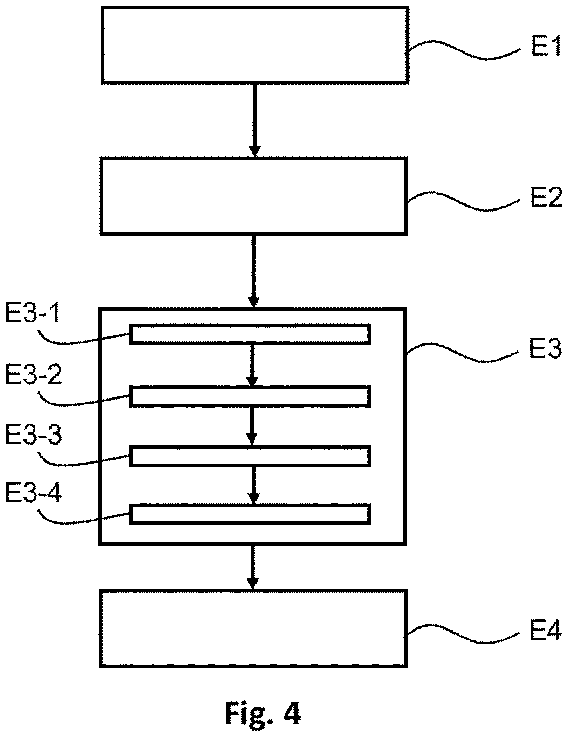

En ce sens, l'invention est relative à un procédé de réglage du système 101 de préhension, ce système 101 de préhension étant destiné à saisir ladite au moins une plaque 103. Un exemple d'enchaînement des étapes de ce procédé de réglage est illustré en figure 4.

La plaque 103 est notamment destinée à la formation d'une cellule photovoltaïque. De préférence, la plaque 103 est destinée à la formation d'une cellule photovoltaïque à base de silicium. Autrement dit, la plaque 103 peut être utilisée comme base pour recevoir les étapes technologiques de fabrication de la cellule photovoltaïque. Ainsi, la plaque 103 peut être une tranche de silicium ; aussi appelée « wafer » en langue anglaise.

Dans la présente description, ce qui s'applique à la plaque 103 peut s'appliquer aux plaques 103 lorsqu'il y en a plusieurs.

Le procédé de réglage comporte une étape E1 de sollicitation du système 101 de préhension contre le dispositif 102 de détection.

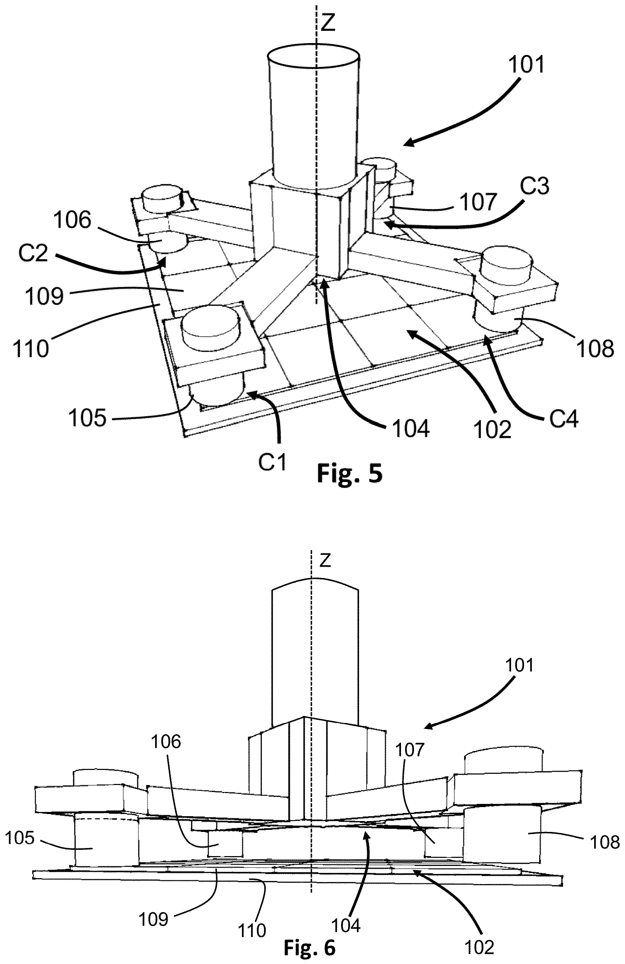

De préférence, le système 101 de préhension peut comporter au moins un dispositif 104 de préhension par exemple déplaçable axialement selon un axe Z. Il en résulte que l'étape E1 de sollicitation peut être mise en œuvre par un rapprochement, selon l'axe Z, du dispositif 104 de préhension par rapport au dispositif 102 de détection. L'axe Z est représenté en pointillé sur la figure 1. Un exemple d'étape E1 de sollicitation du système 101 de préhension contre le dispositif 102 de détection de contrainte est illustré en figures 5 et 6 qui montrent aussi l'axe Z. Dans le cadre de la saisie d'une plaque 103, comme le montre la figure 3, le dispositif 104 de préhension se déplace selon l'axe Z.

Bien entendu, le système 101 de préhension peut être couplé à un mécanisme permettant de le déplacer, aussi appelé moyen de déplacement du système 101 de préhension, par exemple pour permettre la mise en œuvre de l'étape E1 de sollicitation et en particulier réaliser le rapprochement du dispositif 104 de préhension par rapport au dispositif 102 de détection.

Le procédé de réglage comporte une étape E2 de détection de contraintes exercées par le système 101 de préhension sur le dispositif 102 de détection au cours de l'étape E1 de sollicitation. Cette étape E2 de détection permet de récupérer des données qui peuvent ensuite être analysées, par exemple pour en déduire une nécessité de réglage du système 101 de préhension et par exemple pour élaborer des consignes adaptées de réglage du système 101 de préhension.

Ainsi, le procédé de réglage comporte une étape E3 d'analyse des contraintes détectées. C'est cette analyse qui peut permettre de déterminer la nécessité de réglage du système 101 de préhension.

Le procédé de réglage comporte une étape E4 de réglage du système 101 de préhension en prenant en compte l'analyse des contraintes détectées. Autrement dit, les résultats de l'étape E3 d'analyse, peuvent être utilisés pour régler, via l'étape E4 de réglage, le système 101 de préhension de manière adaptée. De préférence, cette étape E4 de réglage est mise en œuvre lorsque l'étape E3 d'analyse met en avant la nécessité de réglage du système 101 de préhension.

En ce sens, le procédé de réglage selon la présente invention propose d'analyser les contraintes qu'exerce le système 101 de préhension en simulant une préhension sur le dispositif 102 de détection. En analysant ces contraintes, il est possible d'assurer le réglage du système 101 de préhension (étape E4) en vue de rendre plus uniforme, c'est-à-dire d'homogénéiser, les contraintes exercés par le système 101 de préhension lors d'une préhension d'une plaque 103 ou de plusieurs plaques 103 en simultané. Il en résulte que cela permet de restreindre l'accentuation de la ou des traces se formant cours de la préhension de la plaque 103 ou de plusieurs plaques 103 en simultané. Ainsi, le procédé de réglage présente l'avantage d'améliorer le rendement de la cellule photovoltaïque obtenue à partir de la plaque 103 saisie par le système 101 de préhension en comparaison du rendement qu'aurait eu la cellule photovoltaïque si le système 101 de préhension n'avait pas été réglé selon le procédé de réglage.

En particulier, l'étape E1 de sollicitation est exécutée de sorte à simuler une préhension sur le dispositif 102 de détection en vue de régler le système 101 de préhension. Ainsi dans ce cas, le procédé de réglage permet de simuler une préhension, par le système 101 de préhension, sur le dispositif 102 de détection de sorte que les contraintes analysées par l'étape E3 d'analyse sont celles de cette simulation de la préhension sur le dispositif 102 de détection.

Dans la présente description, il est entendu par « contrainte », une pression, un effort ou plus généralement tout type de force. Ainsi, la détection d'une contrainte peut correspondre à la détection d'un contact, un tel contact pouvant correspondre à un appui du système 101 de préhension sur le dispositif 102 de détection. La détection de l'appui en tant que contrainte détectée peut aussi associer la valeur de pression de cet appui ainsi que son évolution au cours de l'étape E1 de sollicitation.

Selon une réalisation particulière, en vue d'uniformiser les contraintes exercées par le système 101 de préhension lorsque ce dernier cherche à saisir la plaque 103, il est préférentiellement recherché, au cours du procédé de réglage, à corriger un dérèglement correspondant par exemple à la présence d'au moins deux parties du système 101 de préhension agencées à des niveaux différents d'où il résulte que, lors de la préhension de la plaque 103, ces deux parties viennent en contact avec la plaque 103 à des moments différents. Ceci s'applique aussi par exemple lorsque les deux parties du système 101 de préhension 101 viennent en contact avec deux plaques 103 différentes. Pour répondre à ce besoin de correction, l'étape E3 d'analyse des contraintes détectées comporte une étape E3-1 de détection de différentes zones C1, C2, C3, C4 de contact (figure 5) entre le dispositif 102 de détection et le système 101 de préhension. De préférence, chaque zone C1, C2, C3, C4 de contact détectée correspond à une ou plusieurs contraintes détectées par le dispositif 102 de détection lors de l'étape E2 de détection de contraintes. Autrement dit, la répartition des contraintes détectées par le dispositif 102 de détection est analysée pour déterminer les zones C1, C2, C3, C4 de contact.

Par « niveau», il est entendu que le niveau est donné par rapport à un plan de référence. Notamment, la distance séparant le plan de référence de la partie correspondante du système 101 de préhension définit le niveau de cette partie correspondante du système 101 de préhension, la distance étant mesurée orthogonalement au plan de référence. Le plan de référence peut être un plan horizontal, un plan vertical, ou un plan sécant à la verticale et à l'horizontal. Le plan de référence peut correspondre à un plan orthogonal à la direction de déplacement du système 101 de préhension dans une configuration où le système 101 de préhension cherche à saisir la plaque 103 ou les plaques 103. Une différence de niveau est bien entendu considérée en comparant deux niveaux par rapport au même plan de référence.

Le cas échéant, lorsque le plan de référence est horizontal, par « niveau », il est préférentiellement entendu une hauteur mesurable parallèlement à l'axe Z évoqué ci-avant. Lorsque plusieurs dispositifs 104 de préhension sont présents au sein du système 101 de préhension, les axes Z de ces dispositifs 104 de préhension sont parallèles.

Par « moment de détection », il est entendu un instant particulier qui peut être associé à un horodatage.

Selon cette réalisation particulière, l'étape E3 d'analyse des contraintes détectées comporte aussi une étape E3-2 de vérification d'une présence d'un décalage entre des moments de détection de deux zones, notamment de deux des zones, C1, C2, C3, C4 de contact, ledit décalage étant représentatif d'une différence de niveau entre deux parties du système 101 de préhension. Ces parties du système 101 de préhension sont celles venant en contact avec le dispositif 102 de détection lors de l'étape E1 de sollicitation et provoquant la détection de contraintes correspondantes au cours de l'étape E2 de détection de contraintes, ces contraintes détectées permettant de déterminer les zones C1, C2, C3, C4 de contact correspondantes.

Pour chaque zone C1, C2, C3, C4 de contact détectée, le moment de détection de ladite zone C1, C2, C3, C4 de contact correspond à l'instant où cette zone C1, C2, C3, C4 de contact se forme. Autrement dit, pour chaque zone C1, C2, C3, C4 de contact détectée, le moment de détection de ladite zone C1, C2, C3, C4 de contact correspond préférentiellement à l'instant de détection d'une des contraintes détectées par l'étape E2 de détection de contraintes, cette contrainte détectée permettant de détecter ladite zone C1, C2, C3, C4 de contact.

Lorsque l'étape E3-2 de vérification conduit à la détection de la présence du décalage, l'étape E4 de réglage du système 101 de préhension prend en compte le décalage en vue de, c'est-à-dire de sorte à, corriger la différence de niveau.

Par « corriger la différence de niveau » notamment entre les deux parties du système 101 de préhension, il peut être entendu que la différence de niveau est diminuée le cas échéant pour limiter l'accentuation d'une trace qui serait formée sur la plaque 103 et dont l'accentuation est liée à la différence de niveau. Dans un cas idéal, la réduction de la différence de niveau peut être telle que la différence de niveau est supprimée, c'est-à-dire réduite à zéro, de sorte à positionner lesdites deux parties du système 101 de préhension de manière coplanaires dans un plan appelé plan de préhension du système 101 de préhension. Autrement dit, l'étape E4 de réglage peut prendre en compte le décalage de sorte à diminuer la différence de niveau, de préférence jusqu'à la rendre nulle. Cependant, le cas idéal est difficile à atteindre car il demande des réglages précis coûteux à réaliser : dès lors, une correction correspondant à une simple diminution de la différence de niveau sans suppression de cette différence de niveau est suffisante pour in fine limiter l'accentuation d'une trace, sur la plaque 103, l'accentuation de cette trace étant liée à cette différence de niveau.

De préférence, l'étape E4 de réglage est telle que toutes les parties du système 101 de préhension, destinées à venir en contact avec la plaque 103 ou les plaques 103 lors de la préhension de la plaque 103 ou des plaques 103 réalisée par le système 101 de préhension, sont positionnées, au terme de l'étape E4 de réglage, dans un plan parallèle au plan de référence.

Il a été décrit ci-dessus la vérification de la présence d'un décalage, cependant l'étape E3-2 de vérification peut être telle qu'elle permet de détecter, le cas échéant, une pluralité de décalages chacun étant tel que décrit ci-dessus. Chaque décalage est associé à un couple de parties du système 101 de préhension venant en contact, à des moments de détection différents, avec le dispositif 102 de détection lors de l'étape E1 de sollicitation de telle sorte que les décalages sont préférentiellement utilisés pour placer, via l'étape E4 de réglage, ces parties du système 101 de préhension dans un plan parallèle au plan de référence.

De préférence, le système 101 de préhension comporte des ventouses 105, 106, 107, 108. Les deux parties du système 101 de préhension, venant en contact avec le dispositif 102 de détection au cours de l'étape E1 de sollicitation à des moments décalés, sont formées chacune par une des ventouses 105, 106, 107, 108. Les ventouses 105, 106, 107, 108 sont représentées schématiquement par des cylindres en figures 1, 3, 5, 6, 7 et 8. Les ventouses 105, 106, 107, 108 permettent avantageusement d'assurer une bonne préhension lors de la saisi d'une plaque 103, notamment en exerçant un effet de succion à l'aide d'un vide partiel pour saisir la plaque 103 (figure 3). Le vide partiel peut être relâché ensuite pour poser la plaque 103 par exemple sur le plateau 116 de transport. Ainsi, l'étape E3-1 de détection de différentes zones C1, C2, C3, C4 de contact et l'étape E3-2 de vérification peuvent permettent de détecter, lorsque les ventouses 105, 106, 107, 108 du système 101 de préhension ne sont pas toutes au même niveau, laquelle ou lesquelles des ventouses viennent en contact en premier avec le dispositif 102 de détection en vue procédé à un réglage adapté permettant par exemple de placer toutes les ventouses 105, 106, 107, 108 au même niveau ou de diminuer les différences de niveau sans placer toutes les ventouses 105, 106, 107, 108 au même niveau. Les deux parties du système 101 de préhension, venant en contact avec le dispositif 102 de détection au cours de l'étape E1 de sollicitation, peuvent correspondre à des surfaces des ventouses 105, 106, 107, 108, notamment ces surfaces sont destinées à participer à la saisie de la plaque 103 par le système 101 de préhension.

Notamment, lorsque le système 101 de préhension comporte des ventouses 105, 106, 107, 108, toutes les ventouses 105, 106, 107, 108 viennent en contact avec le dispositif 102 de détection lors de l'étape E1 de sollicitation d'où il résulte la détection des contraintes par l'étape E2 de détection de contraintes, permettant ainsi de détecter autant de zones C1, C2, C3, C4 de contact que de ventouses 105, 106, 107, 108 lors de l'étape E3-1 de détection de différentes zones C1, C2, C3, C4 de contact.

En figure 6, il est représenté le système 101 de préhension, et plus particulièrement le dispositif 104 de préhension, mal réglé lors de son déplacement selon l'axe Z vers le dispositif 102 de détection au cours de l'étape E1 de sollicitation. Sur cette figure 6, on voit clairement que la ventouse 105 est en contact avec le dispositif 102 de détection alors que les autres ventouses 106, 107, 108 sont encore à distance du dispositif 102 de détection. Il en résulte que pour mettre le système 101 de préhension dans un état de préhension dans lequel toutes les ventouses 105, 106, 107, 108 sont couplées au dispositif 102 de détection, il va falloir continuer le déplacement du dispositif 102 de préhension selon l'axe Z pour mettre en contact toutes les autres ventouses 106, 107, 108 avec le dispositif 102 de détection. C'est cette situation qui provoque la formation d'une ou plusieurs traces plus ou moins accentuées lorsque la préhension est réalisée sur une plaque 103 par sollicitation de ces ventouses 105, 106, 107, 108 sur la plaque 103. En ce sens, l'étape E4 de réglage peut être telle quelle permet de positionner toutes les ventouses 105, 106, 107, 108 au même niveau selon l'axe Z et par rapport au plan de référence pour permettre une mise en contact simultanée de toutes ces ventouses 105, 106, 107, 108 avec la plaque 103 lorsque ces ventouses 105, 106, 107, 108 sont utilisées pour saisir la plaque 103. Alternativement, l'étape E4 de réglage peut être telle quelle permet de limiter les différences de niveau entre les ventouses 105, 106, 107, 108.

Ainsi, l'étape E3-1 de détection de différentes zones C1, C2, C3, C4 de contact peut être mise en œuvre pour le dispositif 104 de préhension à ventouses 105, 106, 107, 108 comme le montre les figures 5 et 6. L'étape E3-1 de détection est telle que c'est la mise en contact de chacune des ventouses 105, 106, 107, 108 avec le dispositif 102 de détection qui permet de détecter chaque zone C1, C2, C3, C4 de contact.

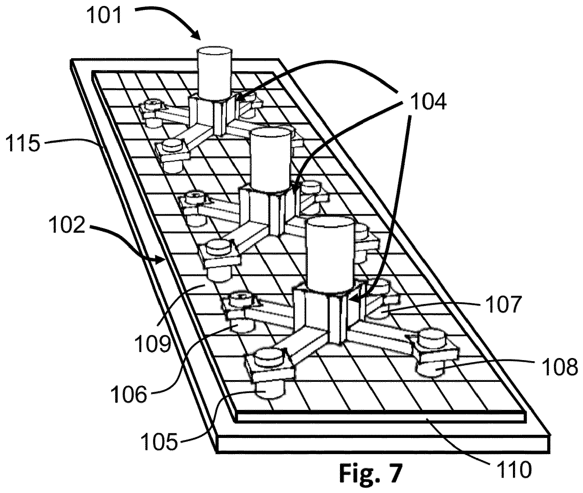

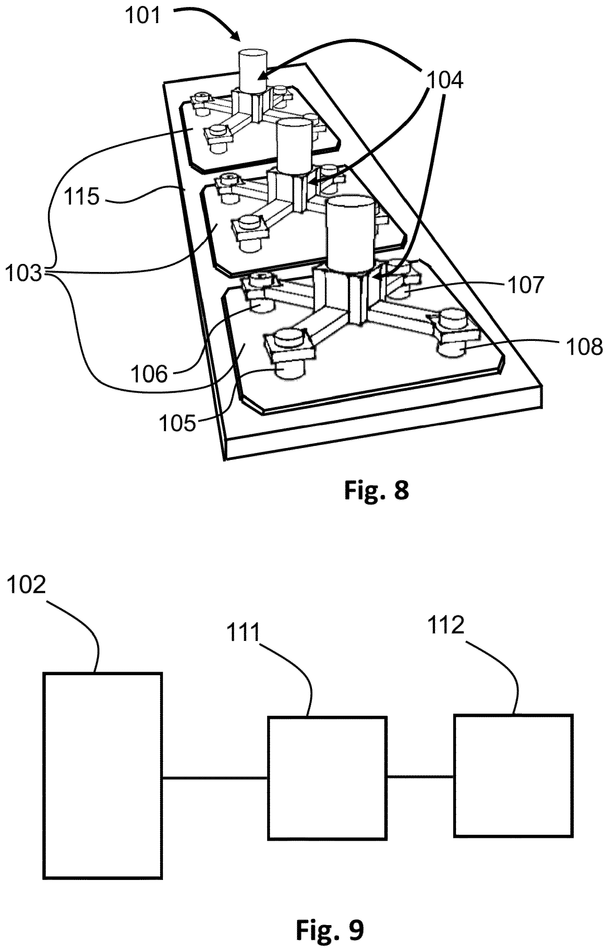

Il a été décrit précédemment le fonctionnement d'un dispositif 104 de préhension par exemple du type à venir saisir une plaque 103 via ses ventouses 105, 106, 107, 108 par exemple au nombre de quatre pour répartir les efforts de préhension sur la plaque 103. Cette réalisation n'est pas limitative dans le sens où le système 101 de préhension peut comporter, comme évoqué précédemment, une pluralité de dispositifs 104 de préhension par exemple à la manière de ce qui est visible en figure 7 qui montre un système 101 de préhension à trois dispositifs 104 de préhension. Ainsi, le système 101 de préhension peut être configuré pour saisir plusieurs plaques 103 de préférence coplanaires. Dans ce cas, le système 101 de préhension comporte une pluralité de dispositifs 104 de préhension et chaque dispositif 104 de préhension est destiné à saisir une des plaques 103 comme le montre par exemple la figure 8 où les plaques 103 à saisir sont placées sur un support 115, ce même support 115 pouvant supporter le dispositif 102 de détection au cours de l'étape E2 de sollicitation (figure 7). Dès lors, chaque contrainte détectée au cours de l'étape E2 de détection de contraintes est une contrainte exercée par l'un des dispositifs 104 de préhension sur le dispositif 102 de détection (figure 7). L'avantage ici est de permettre un réglage du système 101 de préhension même lorsque ce dernier comporte plusieurs dispositifs 104 de préhension de préférence en vue d'homogénéiser les contraintes appliqués par le système 101 de préhension sur les plaques 103.

Par ailleurs, dans le cas du système 101 de préhension à plusieurs dispositifs 104 de préhension, l'étape E4 de réglage peut régler les dispositifs 104 de préhension en vue d'homogénéiser les contraintes exercées par les dispositifs 104 de préhension sur les plaques 103 saisies simultanément par les dispositifs 104 de préhension. Ceci présente l'avantage de régler la planéité du système 101 de préhension pour saisir de manière adaptée plusieurs plaques 103 simultanément afin de limiter l'accentuation de traces lors de leur apparition.

De préférence, les dispositifs 104 de préhension peuvent être chacun tel que décrit précédemment, ils peuvent donc comporter des ventouses 105, 106, 107, 108. Dans ce cas, les ventouses 105, 106, 107, 108 du système 101 de préhension sont agencées de sorte que chaque dispositif 104 de préhension comporte plusieurs ventouses 105, 106, 107, 108 par exemple au nombre de quatre pour répartir les efforts de préhension exercés par le dispositif 104 de préhension correspondant sur la plaque 103 correspondante. L'étape E4 de réglage du système 101 de préhension ajuste alors le positionnement d'une ou de plusieurs des ventouses 105, 106, 107, 108. Cet ajustement permet d'uniformiser les efforts exercés par le système 101 de préhension sur les plaques 103 lors de la préhension des plaques 103 et permet ainsi de limiter le phénomène d'accentuation des traces formées lors de la préhension des plaques 103 par le système 101 de préhension.

Par exemple, l'étape E4 de réglage du système 101 de préhension ajuste le positionnement d'une ou de plusieurs des ventouses 105, 106, 107, 108 de sorte à permettre à ces ventouses 105, 106, 107, 108 de venir simultanément en contact avec les plaques 103 lors de la saisie simultanée de ces plaques 103 comme représenté à titre d'exemple en figure 8. Cette mise en contact simultanée permet d'uniformiser au mieux les efforts exercés par le système 101 de préhension sur les plaques 103 lors de la préhension de ces plaques 103.

De préférence, l'étape E4 de réglage du système 101 de préhension ajuste le positionnement d'une ou de plusieurs des ventouses 105, 106, 107, 108 de sorte à corriger au moins une différence de niveau entre deux des ventouses 105, 106, 107, 108 notamment en prenant en compte le décalage détecté entre les moments de détection de deux des zones C1, C2, C3, C4 de contact entre le dispositif 102 de détection et ces deux ventouses 105, 106, 107, 108. Ceci permet de tendre à uniformiser les efforts exercés sur les plaques 103 lors de la préhension des plaques 103 notamment tout en ne nécessitant pas un réglage trop précis du niveau des ventouses 105, 106, 107, 108 si le réglage ne va pas jusqu'à les positionner au même niveau.

Il résulte de ce qui a été décrit précédemment que le dispositif 102 de détection est préférentiellement capable de détecter des contraintes qui lui sont appliquées en différents points. Pour cela, le dispositif 102 de détection peut comporter une pluralité de capteurs 109 de pression formés sur un substrat 110 (figures 2, 5, 6 et 7) ou peut être formé par un capteur de pression multipoint couvrant en tout ou partie une face du substrat 110.

Les capteurs 109 de pression peuvent être formés chacun par une jauge de contrainte. Les jauges de contrainte sont par exemple imprimées sur le substrat 110. Le substrat 110 peut dans ce cas être un substrat de céramique. L'ensemble formé par substrat 110 et les jauges de contrainte peut présenter une épaisseur par exemple comprise entre 10 µm et 200 µm.

En figures 2, 5, 6 et 7, il est représenté une pluralité de capteurs 109 de pression représentés chacun schématiquement par un carré et par exemple agencés sous la forme d'une matrice. Par exemple, le nombre de ces capteurs 109 de pression peut être supérieur ou égal à 16. Plus le nombre de capteurs 109 de pression est important, plus le réglage du système 101 de préhension sera précis.

Le capteur de pression multipoint présente l'avantage d'augmenter le nombre de points de détection pour détecter les contrainte. Un tel capteur de pression multipoint peut être un capteur de pression capacitif. D'autres avantages d'un tel capteur de pression multipoint sont qui est plus facile à imprimer sur un substrat qu'une pluralité de jauges de contrainte et qu'il permet d'augmenter le nombre zones effectives de détection de contact.

L'augmentation du nombre de points de détection, via la présence d'un capteur de pression mutlipoint ou de capteurs 109 de pression permet de réaliser une cartographie, aussi appelé « mapping » en langue anglaise, fine du comportement de chaque ventouse 105, 106, 107, 108 avec le dispositif 102 de détection dans le sens où, pour chaque ventouse 105, 106, 107, 108, plusieurs points de détection ou capteurs seront impactés par ladite ventouse 105, 106, 107, 108. Ceci permet d'améliorer le réglage du système 101 de préhension en détectant avec une meilleure résolution chaque contact du système 101 de préhension avec le dispositif 102 de détection.

De préférence, le dispositif 102 de détection est relié à une unité 111 de calcul comme le montre un exemple en figure 9. L'unité 111 de calcul est configurée pour interpréter les données issues du dispositif 102 de détection. En ce sens, l'unité 111 de calcul peut mettre en œuvre l'étape E3 d'analyse, pour cela l'unité 111 de calcul peut comporter un programme comportant des instructions permettant cette mise en œuvre de l'étape E3 d'analyse.

Par exemple, chaque capteur 109 de pression peut générer un signal représentatif de la pression qui lui est appliquée, et l'unité 111 de calcul peut acquérir ces signaux en vue de les analyser (étape E3).

Par exemple, le capteur de pression multipoint peut être relié à l'unité 111 de calcul de sorte que, pour chaque zone de détection du capteur de pression multipoint, l'unité 111 de calcul est capable de savoir si une pression est détectée ou non.

Il résulte de ce qui a été décrit précédemment qu'il existe un besoin de présenter les données de l'étape E3 d'analyse de manière efficace et ergonomique pour permettre leur interprétation afin de réaliser le réglage du système 101 de préhension. Pour cela, l'étape E3 d'analyse peut comporter (par exemple comme visible en figure 4) une étape E3-3 d'interprétation des contraintes détectées et une étape E3-4 d'élaboration d'un indicateur pour restituer l'interprétation des contraintes détectées, cette interprétation correspondant aux résultats de l'étape E3-3 d'interprétation, de préférence de manière visuelle pour une personne. L'étape E3-3 d'interprétation et l'étape E3-4 d'élaboration de l'indicateur sont, de préférence, mises en œuvre par l'unité 111 de calcul.

De préférence, l'indicateur est une cartographie des contraintes exercées par le système 101 de préhension sur le dispositif 102 de détection au cours de l'étape E1 de sollicitation. L'avantage d'une telle cartographie est alors de fournir des informations, par exemple à une personne, utilisables pour régler de manière adaptée le système 101 de préhension. La cartographie permet, par exemple, d'identifier quelle ventouse 105, 106, 107, 108 est à régler en priorité pour réduire les différences de niveau entre les ventouses 105, 106, 107, 108 notamment en vue de limiter l'accentuation de traces notamment formées sur la ou les plaques 103 lors de la préhension de cette ou de ces plaques 103 par le système 101 de préhension.

Afin de restituer cet indicateur, l'unité 111 de calcul peut être reliée à une interface homme machine tel qu'un écran 112 (figure 9) et peut générer un signal destiné à l'écran 112, ledit signal permettant d'afficher la cartographie sur l'écran 112. Ceci présente l'avantage de fournir des informations compréhensibles pour une personne s'occupant de la maintenance ou s'occupant du fonctionnement de la ligne de production comportant le système 101 de préhension concerné.

Il a été décrit précédemment une représentation de type cartographie. Cependant, d'autres types de représentation peuvent être envisagés. Par exemple, l'étape E3 d'analyse peut, à la place de générer une cartographie, établir une représentation numérique des valeurs issues du dispositif 102 de détection.

La cartographie peut être enrichie dans le sens où elle peut présenter une couleur variant progressivement en fonction de chaque appui du système 101 de préhension sur le dispositif 102 de détection. Par exemple, chaque zone de la cartographie peut varier du vert, représentant un appui nul du système 101 de préhension pour cette zone, au rouge représentant un appui maximum du système 101 de préhension détecté par le dispositif 102 détection pour cette zone. Entre ces deux couleurs verte et rouge, la couleur peut évoluer pour représenter la progression de l'appui. Ainsi, un code couleur ou des nuances de gris peuvent être utilisés pour enrichir la cartographie.

Il a été décrit ci-avant un système 101 de préhension à ventouses. Le procédé de réglage peut s'appliquer à n'importe quel système 101 de préhension permettant de saisir une ou plusieurs plaques 103, chaque plaque 103 saisie l'étant par l'une de ses faces qui est alors préférentiellement plane. Par exemple, les ventouses 105, 106, 107, 108 du système 101 de préhension, et notamment du dispositif 104 de préhension, peuvent être remplacées par un organe présentant une surface d'aspiration munie de trous d'aspiration pour saisir une plaque 103 correspondante par aspiration. L'inclinaison de cette surface d'aspiration, par rapport au plan de la face via laquelle la plaque 103 sera saisie, provoque la formation, lors de la saisie, d'une trace dont l'accentuation sera importante si l'inclinaison est importante. Le procédé de réglage permet alors un réglage du système 101 de préhension en vue de réduire l'inclinaison ou de positionner la surface d'aspiration afin qu'elle soit parallèle avec la face par laquelle la plaque 103 doit être saisie.

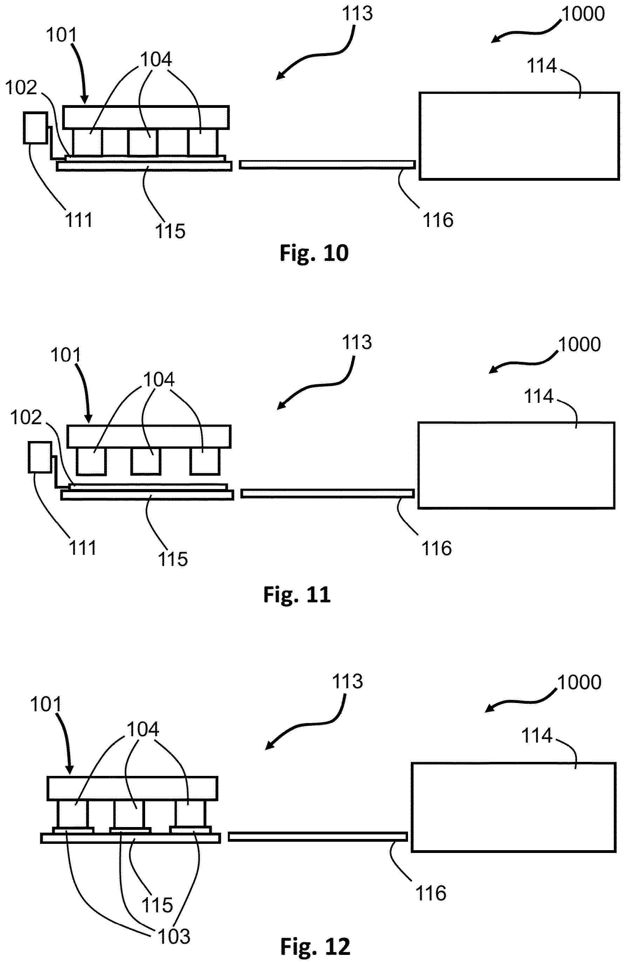

Le procédé de réglage selon la présente invention est tout particulièrement adapté pour régler un système 101 de préhension appartenant à un dispositif 113 de chargement des plaques dans un dispositif 114 de traitement des plaques 103. Dans ce cas, le dispositif 113 de chargement est configuré pour saisir, en utilisant le système 101 de préhension, les plaques 103 placées sur le support 115 (figure 12) et pour transférer ces plaques 103 saisies sur le plateau 116 de transport des plaques 103 destiné à être inséré dans le dispositif 114 de traitement des plaques 103. Le transfert des plaques 103 saisies peut comporter un déplacement du système 101 de préhension vers le plateau 116 de transport après préhension des plaques 103 par le système 101 de préhension, puis le dépôt des plaques 103 sur le plateau 103 de transport en cessant le maintien de ces plaques 103 par rapport au système 101 de préhension. Le dispositif 102 de détection est sur le support 115 au cours de l'étape E1 de sollicitation (figure 10). Autrement dit, au cours de l'étape E1 de sollicitation, le dispositif 102 de détection repose sur le support 115. Ceci présente l'avantage de détecter les contraintes directement dans une situation la plus proche de la préhension des plaques 103 sur leur support 115 en vue d'assurer un réglage pertinent du système 101 de préhension.

De préférence, le dispositif 114 de traitement est configuré pour réaliser un dépôt chimique en phase vapeur assisté par plasma sur les plaques 103, ceci permettant par exemple de fabriquer des cellules photovoltaïques en utilisant les plaques 103. Un tel dispositif 114 de traitement est tout particulièrement adapté dans le domaine de l'électronique pour former des cellules photovoltaïques.

De manière générale, le dispositif 102 de détection présente préférentiellement une épaisseur égale à l'épaisseur de la plaque 103 ou à l'épaisseur des plaques 103. L'épaisseur de la plaque 103 peut être comprise entre 10 µm et 200 µm. Ceci permet de simuler au plus proche la préhension de la plaque 103 ou des plaques 103 sur le dispositif 102 de détection pour réaliser un réglage pertinent du système 101 de préhension.

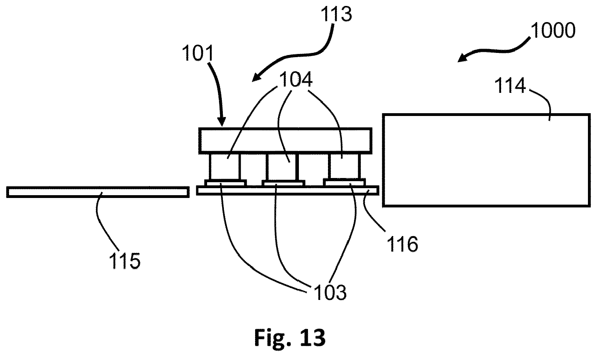

Il résulte de ce qui a été décrit précédemment que l'invention est aussi relative à une installation 1000 par exemple telle que visible en figures 10 à 13, de préférence cette installation 1000 est pour le traitement d'au moins une plaque 103 en vue de former une cellule photovoltaïque en utilisant la plaque 103.

L'installation 1000 comporte le dispositif 102 de détection et le système 101 de préhension pour ladite au moins une plaque 103. Cette 1000 installation comporte alors une configuration de réglage du système 101 de préhension par exemple visible en figures 10 et 11. Le système 101 de préhension est configuré pour présenter, dans la configuration de réglage, une première configuration et une deuxième configuration.

Dans la première configuration, le système 101 de préhension est à distance du dispositif 102 de détection (figure 11).

Dans la deuxième configuration, le système 101 de préhension est sollicité contre le dispositif 102 de détection (figure 10).

L'installation 1000 comporte en outre l'unité 111 de calcul reliée au dispositif de détection pour analyser des contraintes détectées, dans la deuxième configuration, par le dispositif 102 de détection en vue de réaliser le réglage du système 101 de préhension.

En particulier, ces contraintes détectées sont représentatives de la simulation de préhension exécutée sur le dispositif 102 de détection lorsque le système 101 de préhension est sollicité, dans la deuxième configuration, contre le dispositif 102 de détection.

Une telle installation 1000 présente l'avantage de permettre de régler le système 101 de préhension à l'aide de l'analyse des contraintes détectées par exemple de la manière telle que décrite en relation avec le procédé de réglage. Ainsi, l'installation 1000 est notamment configurée pour mettre en œuvre le procédé de réglage.

Bien entendu, l'installation 1000 peut comporter le mécanisme, ou moyen de déplacement, permettant le déplacement du système 101 de préhension pour le mettre en première configuration ou en deuxième configuration.

Dans le cadre de l'installation 1000, le dispositif 102 de détection peut comporter la matrice de capteurs 109 de pression telle que décrite précédemment ou peut être le capteur de pression multipoint tel que décrit précédemment dont les avantages respectifs sont décrits ci-avant.

Dans le cadre de l'installation 1000, le système 101 de préhension est préférentiellement configuré pour saisir une pluralité de plaques 103 de préférence simultanément. L'installation 1000 comporte le dispositif 113 de chargement des plaques 103 dans un dispositif 114 de traitement des plaques 103. Le dispositif 113 de chargement est configuré pour saisir, en utilisant le système 101 de préhension, les plaques 103 placées sur le support 115 et pour transférer ces plaques 103 sur le plateau 116 de transport des plaques 103 destiné à être inséré dans le dispositif 114 de traitement des plaques 103. Le support 115 peut être un convoyeur à bande. Dans la première configuration et dans la deuxième configuration, le dispositif 102 de détection est sur le support 115 notamment à la place des plaques. Ceci présente l'avantage de régler le système 101 de préhension dans des conditions similaires à celles de son utilisation pour saisir les plaques 103. Pour saisir la pluralité de plaques, le système 101 de préhension peut comporter les dispositifs 104 de préhension évoqués ci-avant.

L'installation 1000 peut être telle qu'elle comporte le dispositif 114 de traitement des plaques 103 et/ou le support 115, et/ou le plateau 116 de transport. Alternativement, le dispositif 114 de traitement des plaques et/ou le support 115, et/ou le plateau 116 de transport peuvent être des équipements distincts de l'installation 1000 qui est alors configurée pour coopérer avec ces équipements.

Il résulte de ce qui a été décrit précédemment que le support 115 peut être adapté pour supporter sélectivement les plaques 103 et le dispositif 102 de détection. Autrement dit, le support 115 peut être adapté pour supporter de manière exclusive les plaques 103 et le dispositif 102 de détection.

Dans le cadre de l'installation 1000 comportant plusieurs dispositifs 104 de préhension, chaque dispositif 104 de préhension peut saisir une plaque 103 correspondante placée sur le support 115.

Le dispositif 113 de chargement peut comporter le système 101 de préhension, le plateau 116 de transport, des moyens permettant de piloter le système 101 de préhension pour lui permettre de saisir les plaques 103 placées sur le support 115 et de les déplacer pour les positionner sur le plateau 116 de transport où ces plaques 103 sont relâchées par le système 101 de préhension, des moyens permettant d'insérer le plateau 116 de transport dans le dispositif 114 de traitement des plaques pour y traiter les plaques 103 posées sur le plateau 116 de transport.

Le plateau 116 de transport peut comporter des logements adaptés pour les plaques.

En figures 7, 10 et 11, il est représenté un dispositif 102 de détection adoptant une forme lui permettant de coopérer simultanément avec les dispositifs 104 de préhension lors de l'étape E1 de sollicitation. Cette réalisation est préférée car elle permet d'ajuster aisément le niveau des dispositifs 104 de détection les uns par rapport aux autres en vue de régler la planéité globale du système 101 de préhension.

Alternativement, le dispositif 102 de détection peut comporter autant de détecteurs pour détecter des contraintes que de dispositifs 104 de préhension ; cependant cela nécessite alors de positionner dans un même plan les détecteurs s'il est souhaité de régler le niveau des dispositifs 104 de préhension les uns par rapport aux autres.

Selon une variante, le dispositif 102 de détection peut s'utiliser successivement avec chacun des dispositifs 104 de préhension. Cependant, cela implique que, pour chaque dispositif 104 de préhension, le procédé de réglage comporte un ensemble d'étapes comprenant l'étape E1 de sollicitation, l'étape E2 de détection de contraintes et l'étape E3 d'analyse mises en œuvre pour ledit dispositif 104 de préhension. Il est alors plus difficile d'assurer un réglage de la planéité globale du système 101 de préhension à cause des déplacements du dispositif 102 de détection nécessaires pour mettre en œuvre les différents ensembles d'étapes et des détections des contraintes qui ne seront pas réalisées lors d'une même étape de sollicitation.

Bien entendu, ce qui s'applique dans le cadre du procédé de réglage peut s'appliquer à l'installation 1000 et inversement ce qui s'applique dans le cadre de l'installation 1000 peut s'appliquer au procédé de réglage.

Le procédé de réglage et l'installation présentent chacun une application industrielle notamment dans le cadre du traitement de plaque(s) pour former des cellules photovoltaïques.

## Revendications

1. Procédé de réglage d'un système (101) de préhension, le système (101) de préhension étant destiné à saisir au moins une plaque (103), la plaque (103) étant destinée à la formation d'une cellule photovoltaïque, **caractérisé en ce qu'**il comporte :
• une étape (E1) de sollicitation du système (101) de préhension contre un dispositif (102) de détection configuré pour détecter des contraintes,
• une étape (E2) de détection de contraintes exercées par le système (101) de préhension sur le dispositif (102) de détection au cours de l'étape (E1) de sollicitation,
• une étape (E3) d'analyse des contraintes détectées,
• une étape (E4) de réglage du système (101) de préhension en prenant en compte l'analyse des contraintes détectées.

2. Procédé de réglage selon la revendication 1, **caractérisé en ce que** l'étape (E3) d'analyse des contraintes détectées comporte :
• une étape (E3-1) de détection de différentes zones (C1, C2, C3, C4) de contact entre le dispositif (102) de détection et le système (101) de préhension,
• une étape (E3-2) de vérification d'une présence d'un décalage entre des moments de détection de deux zones (C1, C2, C3, C4) de contact, ledit décalage étant représentatif d'une différence de niveau entre deux parties du système (101) de préhension,
et **en ce que**, l'étape(E3-2) de vérification ayant conduit à la détection de la présence du décalage, l'étape (E4) de réglage du système (101) de préhension prend en compte le décalage en vue de corriger la différence de niveau.

3. Procédé de réglage selon la revendication précédente, **caractérisé en ce que** le système (101) de préhension comporte des ventouses (105, 106, 107, 108), les deux parties du système (101) de préhension étant formées chacune par une des ventouses (105, 106, 107, 108).

4. Procédé de contrôle selon l'une quelconque des revendications 1 à 3, **caractérisé en ce que** le système (101) de préhension est configuré pour saisir plusieurs plaques (103), le système (101) de préhension comportant une pluralité de dispositifs (104) de préhension, chaque dispositif (104) de préhension étant destiné à saisir une des plaques (103), et **en ce que** chaque contrainte détectée au cours de l'étape (E2) de détection de contraintes est une contrainte exercée par l'un des dispositifs (104) de préhension.

5. Procédé de réglage selon la revendication 4 et la revendication 3, **caractérisé en ce que** :
• les ventouses (105, 106, 107, 108) sont agencées de sorte que chaque dispositif (104) de préhension comporte plusieurs ventouses (105, 106, 107, 108), et
• l'étape de réglage (E4) du système (101) de préhension ajuste le positionnement d'une ou de plusieurs des ventouses (105, 106, 107, 108).

6. Procédé de réglage selon l'une quelconque des revendications 4 à 5, **caractérisé en ce que** :
• le système (101) de préhension appartient à un dispositif (113) de chargement des plaques (103) dans un dispositif (114) de traitement des plaques (103), ledit dispositif (113) de chargement étant configuré pour saisir, en utilisant le système (101) de préhension, les plaques (103) placées sur un support (115) et pour les transférer sur un plateau (116) de transport des plaques (103) destiné à être inséré dans le dispositif (114) de traitement des plaques (103),
• le dispositif (102) de détection est sur le support (115) au cours de l'étape (E1) de sollicitation.

7. Procédé de réglage selon la revendication 6, **caractérisé en ce que** le dispositif (114) de traitement est configuré pour réaliser un dépôt chimique en phase vapeur assisté par plasma sur les plaques (103).

8. Procédé de réglage selon l'une quelconque des revendications précédentes, **caractérisé en ce que** l'étape (E3) d'analyse comporte une étape (E3-3) d'interprétation des contraintes détectées et une étape (E3-4) d'élaboration d'un indicateur pour restituer l'interprétation des contraintes détectées.

9. Procédé de réglage selon la revendication précédente, **caractérisé en ce que** l'indicateur est une cartographie des contraintes exercées par le système (101) de préhension sur le dispositif (102) de détection au cours de l'étape (E1) de sollicitation.

10. Procédé de réglage selon l'une quelconque des revendications précédentes, **caractérisé en ce que** le réglage du système (101) de préhension est réalisé, en vue de rendre plus uniforme les contraintes exercées par le système (101) de préhension lors d'une préhension de la plaque (103), par correction d'un dérèglement correspondant à la présence d'au moins deux parties du système (101) de préhension agencées à des niveaux différents par rapport à un plan de référence.

11. Procédé de réglage selon l'une quelconque des revendications précédentes, **caractérisé en ce que** le système (101) de préhension permet de saisir la plaque (103) par l'une de ses faces.

12. Installation (1000) comportant un système (101) de préhension pour au moins une plaque (103), la plaque (103) étant destinée à la formation d'une cellule photovoltaïque, **caractérisée en ce que** l'installation (1000) comporte :
• un dispositif (102) de détection pour détecter des contraintes,
• une configuration de réglage du système (101) de préhension, ledit système (101) de préhension étant configuré pour présenter, dans la configuration de réglage, une première configuration et une deuxième configuration, dans la première configuration le système (101) de préhension étant à distance du dispositif (102) de détection, dans la deuxième configuration le système (101) de préhension étant sollicité contre le dispositif (102) de détection,
• une unité (111) de calcul reliée au dispositif (102) de détection pour analyser des contraintes détectées, dans la deuxième configuration, par le dispositif (102) de détection en vue de réaliser un réglage du système (101) de préhension.

13. Installation (1000) selon la revendication précédente, **caractérisée en ce que** le dispositif (102) de détection comporte une matrice de capteurs (109) de pression.

14. Installation (1000) selon la revendication 12, **caractérisée en ce que** le dispositif (102) de détection est un capteur de pression multipoint.

15. Installation (1000) selon l'une quelconque des revendications 12 à 14, **caractérisée en ce que**, le système (101) de préhension étant configuré pour saisir une pluralité de plaques (103), l'installation (1000) comporte un dispositif (113) de chargement des plaques (103) dans un dispositif (114) de traitement des plaques (103), ledit dispositif (113) de chargement étant configuré pour saisir, en utilisant le système (101) de préhension, les plaques (103) placées sur un support (115) et pour les transférer sur un plateau (116) de transport des plaques (103) destiné à être inséré dans le dispositif (114) de traitement des plaques (103), et **en ce que**, dans la première configuration et dans la deuxième configuration, le dispositif (102) de détection est sur le support (115).
